# EUROPEAN PATENT APPLICATION

(11) **EP 4 852 691 A1**
(43) Date of publication of application: **09.12.2026**
(21) Application number: 25180209.6
(22) Date of filing: 02.06.2025
(51) Int. Cl.: H10N 60/12, H10N 60/01

(54) **A JOSEPHSON JUNCTION DEVICE AND METHOD OF PREPARING THE SAME**

(71) Applicant: Nederlandse Organisatie voor Toegepast-Natuurwetenschappelijk Onderzoek TNO, 2595 DA 's-Gravenhage (NL)
(72) Inventor: The designation of the inventor has not yet been filed
(74) Representative: Nederlandsch Octrooibureau

(57) **Abstract**

A Josephson junction device comprising a substrate having a surface, a first superconducting electrode layer formed on the surface of the substrate, a dielectric insulator layer formed on a surface of the first superconducting electrode layer, a second superconducting electrode layer formed on a surface of the dielectric insulator layer, wherein said first and second superconducting electrode layers comprise aluminium, and said dielectric insulator layer comprises Aluminium Fluoride, AlF₃.

## Description

### BACKGROUND OF THE INVENTION

### Field of the Invention

The present invention generally relates to a Josephson junction devices and methods of forming Josephson junction devices. More particularly, the invention relates to a Josephson junction device that utilises an aluminium fluoride insulating layer and the method of formation of such a Josephson junction device.

### Description of the Related Art

A Josephson junction is a quantum device, which comprises two layers of superconducting material separated by a thin insulating layer. The insulating layer enables the phenomenon known as quantum tunnelling, whereby Cooper pairs of electrons can pass through the insulating layer without any classical current flow. This tunnelling behaviour is fundamental to the operation of the Josephson junction and enables their application as superconducting quantum bits (qubits). Josephson junctions have received significant attention due to their unique ability to maintain a superconducting current even in the presence of zero voltage, which creates the necessary conditions for a quantum interface. As such, Josephson junction devices have been found uses in quantum computing, voltage standards, microwave detectors, photon detectors, among others. The key to the Josephson junction device's operation as superconducting qubits and quantum microwave resonators is its ability to create quantum coherence.

The quantum coherence of a Josephson junction is impacted by material imperfections such as defects, dielectric losses, and surface oxides. The current state-of-the-art Josephson junction devices largely focus on aluminium-aluminium oxide-aluminium (Al-AlOx-Al) systems, such as US10340438 B2 and WO 2022031590 A1.

As such, it would be advantageous for a Josephson junction device to have an insulating layer that exhibits good quantum coherence and is easily reproducible, enabling better qubit performance and consistency in manufacturing.

### BRIEF SUMMARY OF THE INVENTION

Accordingly, there is provided a Josephson junction device comprising a substrate having a surface; a first superconducting electrode layer formed on the surface of the substrate; a dielectric insulator layer formed on a surface of the first superconducting electrode layer; a second superconducting electrode layer formed on a surface of the dielectric insulator layer, wherein said first and second superconducting electrode layers comprise aluminium; and said dielectric insulator layer comprises Aluminium Fluoride (AlF₃).

Previous solutions for forming Josephson junctions have focused on using Aluminium Oxide (AlOx) as the dielectric insulator layer. However, AlOx exhibits a high two-level-system (TLS) density, which leads to qubit decoherence due to dipole defects in the disordered oxide. This dielectric loss associated with the AlOx dielectric insulator layer negatively affects the performance of the Josephson junction in applications such as quantum qubits and microwave resonators. Furthermore, the AlOx dielectric insulator layer growth is hard to control, as over-oxidation can lead to too thick a dielectric insulator layer, resulting in lower current. Oxidation also results in rougher, less uniform interfaces, which can vary junction-to-junction and make reproducibility of Josephson junction devices hard to control. As such, these negative characteristics of AlOx as the dielectric insulator layer in a Josephson junction have significant ramifications when these devices are used as qubits and microwave resonators, which necessitate that the TLS noise, interface roughness, and dielectric loss all be minimised.

According to the present proposal, the dielectric insulator layer of the Josephson junction is formed from AlF₃. The AlF₃ layer may improve performance as a dielectric insulator layer over AlOx, namely in terms of its very low TLS noise, smooth interfaces, and low dielectric loss. AlF₃ possesses strong, highly ionic bonding which, unlike the covalent bonds of AlOx, suppresses TLS activity as AlF₃ is less prone to forming polarisable defect dipoles. The high bond energy and stability of AlF₃ also results in fewer broken bonds, leading to fewer fluctuating TLS. AlF₃ can be grown by layer-by-layer deposition methods, such as atomic layer deposition (ALD), ensuring angstrom-level control over film thickness and uniformity, resulting in crystalline or quasi-crystalline AlF₃ dielectric insulator layers, which reduces scattering and defect formation. Lastly, the few mobile or fluctuating dipoles, low permittivity of AlF₃ compared to AlOx, stable wide bandgap, and fewer defect states result in a very low dielectric loss, whereby the loss tangent is two orders of magnitude less for AlF₃ than for AlOx. This makes Josephson junction devices comprising an AlF₃ dielectric insulator layer particularly suitable for use in superconducting qubits and microwave resonators and cavities.

The Josephson junction device may possess any appropriate thickness of dielectric insulator layer, so long as it is sufficiently thin to allow for optimal quantum tunnelling of Cooper pairs. Furthermore, the thinner the dielectric insulator layer, the more precise the tuning of the critical current for use in a qubit or resonator. As such, the thickness of the dielectric insulator layer may be in the range of 1 - 2.5 nanometres (nm). However, to achieve better coherence whilst balancing the critical current tuning capability, the thickness of the dielectric insulator layer is preferably in the range of 1 - 2 nm. Most optimal performance, considering critical current and coherence, is achieved in the range of 1 - 1.4 nm, and as such is most preferred, particularly when constructing high performance qubits.

The Josephson junction device may also possess any thickness of first and second superconducting electrode layers. The thickness of the first and second superconducting electrode layers may be the same or different, however preferably the second superconducting electrode layer is thicker than the first superconducting electrode layer. A thicker second superconducting electrode layer protects the Josephson junction during further processing, e.g. during lithography and etching, and allows for better electrical contact and current carrying by reducing sheet resistance and minimising current crowding. Therefore, the thickness of the first superconducting electrode layer is preferably in the range of 20 - 40 nm, and the thickness of the second superconducting electrode layer is preferably in the range of 80 - 150 nm. These ranges ensure the greatest structural protection, lowest resistance, and best quasiparticle management of the Josephson junction device. However, the first superconducting electrode layer and the second superconducting electrode layer may have any other suitable thickness.

The Josephson junction device may be constructed in any way and by any means suitable for the function of the Josephson junction. As such, the Josephson junction may be fully amorphous, fully crystalline, or contain layers that are amorphous and layers that are crystalline. Both the first and second superconducting electrode layers and the dielectric insulator layer are capable of being either amorphous or crystalline layers. However, preferably all layers of the Josephson junction, including the first and second superconducting electrode layers and the dielectric insulator layer, are epitaxial and crystalline. Having epitaxial, crystalline layers dramatically reduces the TLS as the layers possess an ordered lattice, which has fewer fluctuating dipoles, less electric field noise, and reduced dielectric loss. Furthermore, the sharper interfaces conferred by the atomically-flat epitaxial layers results in uniform dielectric insulator layer thickness, giving a predictable critical current and uniform tunnelling across the Josephson junction device. Crystalline dielectrics also have lower dielectric loss than amorphous dielectrics. Regarding superconductivity, crystalline superconductors exhibit better superconducting gap uniformity, lower normal resistance, and fewer weak links, making the superconducting electrode layers more stable during operation under high currents or magnetic fields. For these reasons, a preferred embodiment of the present invention possesses fully crystalline, epitaxial layers.

The Josephson junction device can comprise additional non-Al material layers within the first and second superconducting electrode layers, provided that there is always a layer of aluminium present at the interface between the first and second superconducting electrode layers and the dielectric insulating layer. The additional non-Al material layers can be of any thickness and there can be any number of additional material layers within the first and second superconducting electrode layers. The first superconducting electrode layer may contain additional non-Al material layers whereas the second superconducting electrode layer may contain any additional non-Al material layers, and vice versa. Furthermore, the additional non-Al material layers of the first superconducting electrode layer do not have to be the same as those of the second superconducting electrode layer, and the number of additional non-Al material layers in the first superconducting electrode does not have to be the same as for the second superconducting electrode layer. As such, an asymmetric Josephson junction may be formed. The additional non-Al material layer may be formed from Niobium (Nb), Tantalum (Ta), Titanium (Ti), Thallium (Tl), Molybdenum Rhenium (MoRe), or any other suitable material. The inclusion of additional non-Al material layers in the first and second superconducting electrode layer has the benefit of increasing the critical temperature, enabling faster qubits, improved interface engineering, and greater thermal conductivity. A symmetric Josephson junction may be obtained by adding other additional layers, for instance by having sequential layers of Nb, Al, AlF3, Al and Nb.

The dielectric insulating layer can also comprise additional non-AlF₃ material layers, provided that there is always a layer of AlF₃ present at the interface between the dielectric insulating layer and the first and second superconducting electrode layers. There may be any number of additional non-AlF₃ layers present in the dielectric insulating layer, and further the additional non-AlF₃ layers may be of any thickness, provided the total thickness of the dielectric insulating layer is still within a suitable range. In a preferred embodiment, the dielectric insulating layer comprises a single non-AlF₃ material layer, being an AlOx layer. This combination balances the dielectric loss and TLS noise associated with AlOx by sandwiching it with AlF₃ in the dielectric insulating layer, whilst capitalising on the strong quantum tunnelling properties of AlOx. However, any other suitable dielectric material can be utilised for the non-AlF₃ material layer in the dielectric insulating layer.

The Josephson junction device may also possess a protective layer on the surface of the second superconducting electrode layer. The protective layer may be of any thickness such that it confers the necessary passivation and protection to the device. The protective layer may also be formed of any suitable material that exhibits structural and environmental stability, and may be deposited in any suitable way such that a uniform layer is achieved. The protective layer is preferably formed from Silicon Nitride (SiNₓ), which is highly impermeable to moisture, oxygen, and alkali ions, and thus can prevent oxidation or degradation of the second superconducting electrode layer or junction area. Furthermore, SiNₓ is chemically and thermally stable up to 1000 degree Celsius (°C), is a good electrical insulator, and can be deposited by vapour deposition. Any dielectric like Silicon Dioxide (SiO₂), Silicon Nitride (Si₃N₄), Alumina (Al₂O₃) or Hafnia (HfO₂) among other may be used for this purpose.

The substrate of the Josephson junction may be formed of any electrically-insulating, non-magnetic material that comprises an atomically-smooth, defect-free surface. Preferably, the substrate will be crystalline and epitaxial, having a single crystal orientation to support the epitaxial growth of the Josephson junction. The substrate (100) may be any material from the group consisting of a Magnesium Oxide (MgO), Silicon (Si) substrate, Silicon Dioxide (SiO₂), Strontium Titanate (SrTiO₃), yttrium-stabilised zirconia (YSZ), and Al₃O₃ crystalline, however other possibilities are not excluded. In a preferred embodiment, a Si substrate is used as it is particularly compatible with complementary metal-oxide semiconductor (CMOS) fabrication, enabling facile integration of the Josephson junction device.

The Josephson junction device may be manufactured using any suitable thin film deposition method to achieve the steps of forming on a portion of the planar surface of the substrate a thin film of Al superconducting layer, further forming a thin film of AlF₃ dielectric insulating layer on the surface of the Al thin film, and further forming a thin film of Al superconducting layer on the surface of the AlF₃ thin film. For example, the thin film deposition may be via thermal or electron beam (e-beam) metal deposition, sputtering, ALD, chemical vapour deposition (CVD), or molecular beam epitaxy (MBE).

Most commonly, Josephson junctions are manufactured using a combination of shadow evaporation followed by in-situ oxidation. Thus, by oxidizing the surface of Al, AlOx can be formed.

Growing the Josephson junction by an angled evaporation method, often called the double-angle evaporation or shadow evaporation technique allows making overlap-type Josephson junctions, particularly for quantum devices like superconducting qubits. This method enables metal deposition from different angles to define the first and second superconducting electrode in a single step without breaking vacuum. Between the two steps the in-situ oxidation of the electrode allows the formation of the thin oxide barrier. Using the shadow evaporation technique one can fabricate Al-AlF3-Al junctions by a small modification., The method steps may comprise: preparing the substrate; forming a Dolan bridge using a bilayer resist system; using e-beam lithography to pattern the bridge; thermally or e-beam evaporating Al to form the first superconducting electrode layer; fluorinating the Al layer in-situ via plasma-assisted fluorination to form the dielectric insulating layer; thermally or e-beam evaporating Al to form the second superconducting electrode layer under a different angle; and dissolving the resist in a lift-off process. Any appropriate means of performing each method step may be used. Furthermore, method steps may be omitted or additional method steps may be added.

Any of the above method claims may include additional steps for depositing non-Al layers in the first and second superconducting electrode layer and non-AlF₃ layers in the dielectric insulating layer. The non-Al layers may be deposited by the same method as used for depositing the Al layers of the first and second superconducting electrode layer, or a different appropriate method may be used. The non-Al layers may be deposited at any appropriate point during the construction of the Josephson junction device, provided the interface surface, being the surface in contact with the dielectric insulating layer, of the first and second superconducting electrode layers is not a non-Al layer. Similarly, the non-AlF₃ layers may be deposited by the same method as used for depositing the AlF₃ layers of the dielectric insulating layer, or a different appropriate method may be used. The non-AlF₃ layers may be deposited at any appropriate point during the construction of the Josephson junction device, provided the interface surface, being the surface in contact with the first and second superconducting electrode layers, is not a non-AlF₃ layer.

A protective coating may also be grown on the surface of the second superconducting electrode of the Josephson junction device. The protective coating provides a passivating layer, preferably covering the entire Josephson junction device, which prevents physical damage, chemical damage, and environmental degradation of the device, as well as providing electrical and dielectric isolation. The protective coating may comprise any material that is chemically compatible with the other materials in the device and should not degrade the superconducting properties of the device. In a preferred embodiment, the protective coating may be a layer of AlOx formed by oxidation of the Al-surface of the second superconducting electrode layer, or a layer of AlF₃ formed by plasma-assisted fluorination of the Al-surface second superconducting electrode layer. However, inorganic protective coatings may also be deposited by ALD, CVD, spin-coating, self-assembled monolayers (SAMs), physical vapour deposition (PVD), or otherwise. The material of the protective coating may also be chosen and/or further functionalised to enhance or produce a specific desired property of the Josephson junction device, such as chemical resistance, electrical insulation, hydrophobicity, thermal stability, mechanical protection, plasma resistance, conformal coverage, planarization or dielectric control.

### BRIEF DESCRIPTION OF THE DRAWINGS

The features and advantages of the invention will be appreciated upon reference to the following drawings of a number of exemplary embodiments, in which:
Figure 1 shows a schematic illustration of the Josephson junction device according to the invention;
Figure 2 shows a schematic illustration of an alternative arrangement of the Josephson junction device of Figure 1;
Figure 3 shows a schematic illustration of an alternative arrangement of the Josephson junction device of Figure 1;
Figure 4 shows a schematic illustration of the Josephson junction device of Figure 1, further comprising a protective coating;
Figure 5 shows a schematic illustration of a method of manufacture of the Josephson junction device of Figure 4; and
Figure 6 shows a schematic illustration of an alternative method of manufacture of the Josephson junction device of Figure 4.

### DESCRIPTION OF THE ILLUSTRATIVE EMBODIMENTS

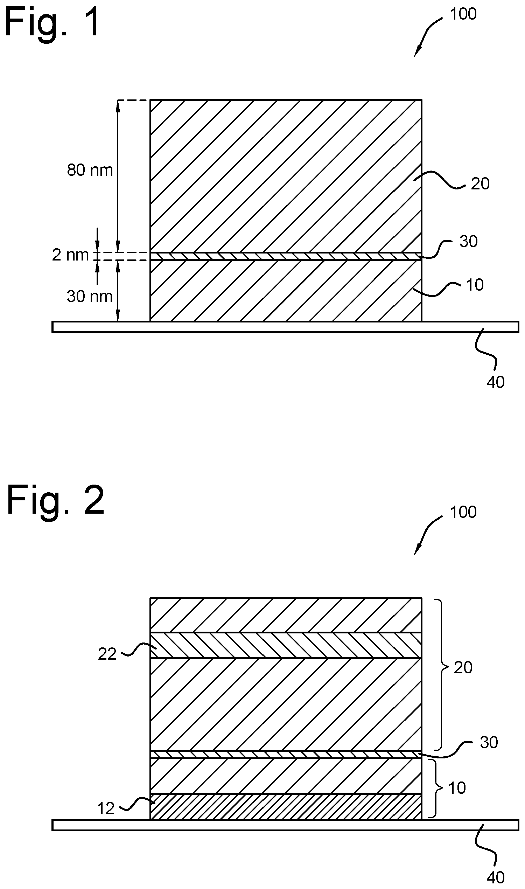

Figure 1 shows a schematic illustration of the Josephson junction device 100 according to the invention. The Josephson junction device 100 comprises a flat substrate 40, a first superconducting electrode layer 10 formed on the surface of the substrate 40, a dielectric insulator layer 30 formed on the surface of the first superconducting electrode layer 10, and a second superconducting electrode layer 20 formed on the surface of the dielectric insulator layer 30. The flat substrate 40 is made from Si, having crystal orientation suitable for epitaxial growth of the Josephson junction on its surface. The first superconducting electrode layer 10 and second superconducting electrode layer 20 are both formed from Al, and the dielectric insulator layer 30 is formed from AlF₃. The use of Al and AlF₃ to form the Josephson junction enables greater versatility in the fabrication of the device 100, as these materials are compatible with PVD, ALD, and e-beam deposition methods, leading to greater thickness control and better uniformity of the deposited layers. AlF₃ also offers improved dielectric properties, having a lower dielectric loss tangent than AlOx, which results in less energy dissipation and better quantum performance in superconducting qubits or microwave resonators.

As seen in Figure 1, the AlF₃ dielectric insulator layer 30 is very thin, with a thickness of 2 nm. The thin AlF₃ layer 30 supports the Josephson current as the thinner AlF₃ layer enables greater probability of quantum tunnelling. The first Al superconducting electrode layer 10 has a thickness of 5 nm, whereas the second Al superconducting electrode layer 20 has a thickness of 40 nm. The thicker second Al superconducting electrode layer 20 gives better electrical conductivity and improved mechanical stability during fabrication, i.e. during lift-off in CMOS fabrication. As such, these layer thicknesses give optimal Josephson junction device 100 performance.

Figure 2 shows a schematic illustration of the Josephson junction device 100 of Figure 1, further comprising non-Al layers 12,22 in the first superconducting electrode layer 10 and second superconducting electrode layer 20. The Josephson junction device 100 of Figure 2 is an asymmetric Josephson junction, enabling greater ability to tailor the electrical, structural, and quantum properties of the device 100. The non-Al layer 12 of the first superconducting electrode layer 10 is formed from Nb, which has a higher critical temperature than Al and exhibits the highest compatibility with silicon technology. As such, the addition of a Nb non-Al layer 12 to the first superconducting electrode layer 10, wherein the Nb layer 12 is grown directly on the Si substrate 40, offers better interface control with the Si substrate 40 due to their lattice matching, allowing more reproducible interfaces with enhanced suitability for use in qubits and voltage standards. The non-Al layer 22 of the second superconducting electrode layer 20 is formed from Ta, which has a very high critical temperature and exhibits lower dielectric loss than Al due to it having fewer TLS defects. The addition of the Ta non-Al layer 22 to the second superconducting electrode layer 20 results in improved qubit coherence times during use of the Josephson junction device 100 in next-generation transmon qubits. Incorporation of the non-Al layers 12,22 into the first and second superconducting electrode layers 10,20 enables the electrical, structural, and quantum properties of the Josephson junction device 100 to be tailored, resulting in improved performance.

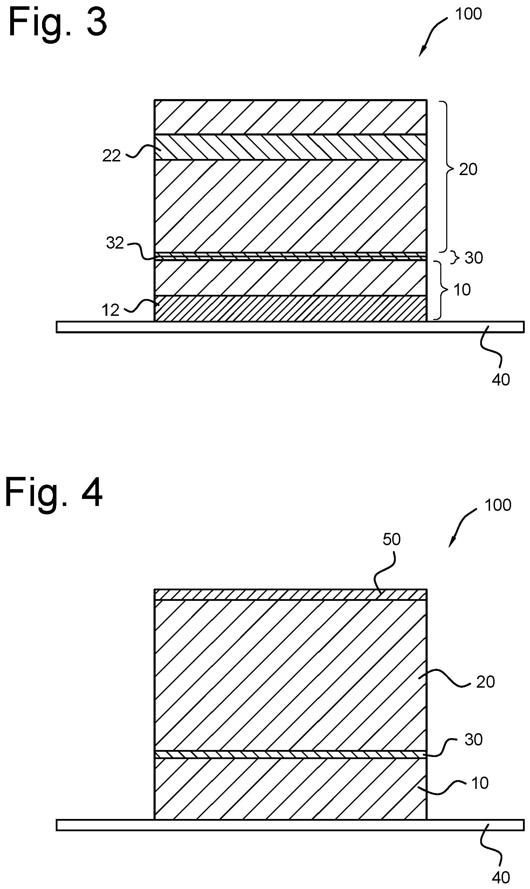

Figure 3 shows a schematic illustration of the Josephson junction device 100 of Figure 2, which further comprises a non-AlF₃ layer 32 in the dielectric insulator layer 30. The stacking of dielectric materials to form a multilayer dielectric insulator layer 30 offers improved performance due to the reduction of TLS and improved tunnelling uniformity. The non-AlF₃ layer 32 is formed from Al₂O₃, which, in combination with the AlF₃ already comprising the dielectric insulator layer, offers interface control as the AlF₃ can passivate the Al₂O₃ interface and improve tunnelling barrier performance, as the high density of TLS in Al₂O₃ is balanced by the lower TLS density of AlF₃. Furthermore, the effective barrier height and critical current of the dielectric insulator layer 30 is tuned by controlling the thickness of both the Al₂O₃ non-AlF₃ layer 32 and the AlF₃ of the dielectric insulator layer 30.

Figure 4 shows a schematic illustration of the Josephson junction device 100 of Figure 1, further comprising a protective layer 50 formed on the surface of the second superconducting electrode layer 20. Addition of a protective layer 50 on the surface of the second superconducting electrode layer 20 preserves the performance and stability of the junction over time, particularly in quantum devices such as qubits, where small imperfections can cause a significant deterioration in performance. The protective layer 50 can be a layer of SiNₓ, which seals the surface of the second superconducting electrode layer 20 and prevents oxide growth or TLS-induced decoherence. The protective layer 50 further protects the Josephson junction device 100 from environmental degradation caused by exposure to moisture and oxygen, as well as damage that can be incurred during fabrication.

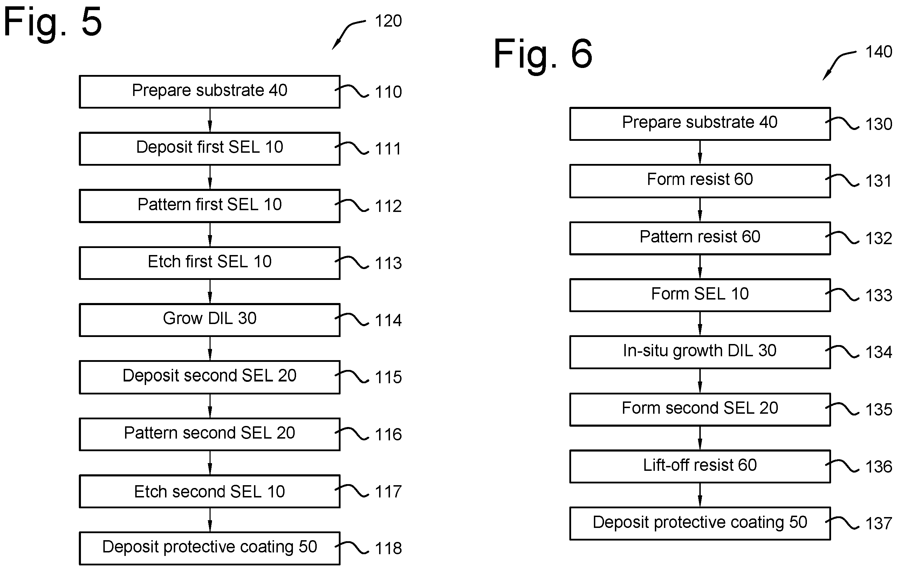

Figure 5 shows a schematic illustration of a method 120 of manufacture of the Josephson junction device 100 of Figure 4. The method 120 comprises steps 110 to 118 to form the Josephson junction device 100. Step 110 involves preparing the Si substrate 40 for deposition by cleaning with acetone, isopropyl alcohol, and deionised water to remove any organic contaminants, followed by irradiating the surface of the Si substrate 40 with O₂ plasma. O₂ plasma functionalises the surface of the Si substrate 40 by forming oxide groups, which facilitates the binding of the first superconducting electrode layer 10 with the Si substrate 40. Step 111 involves deposition of the Al first superconducting electrode layer 10 on the surface of the Si substrate 40, whereby the Al first superconducting electrode layer 10 is deposited by sputtering. The deposited Al first superconducting electrode layer 10 is patterned in step 112 using e-beam lithography, which is then etched by RIE in step 113 to form a patterned surface on the Al first superconducting electrode layer 10. The AlF₃ dielectric insulating layer 30 is then grown on the patterned surface of the Al first superconducting electrode layer 10 by CVD in step 114. The Al second superconducting electrode layer 20 is then deposited by sputtering on the surface of the dielectric insulating layer 30 in step 115. The junction overlap of the Josephson junction device 100 is then patterned in step 116 by e-beam lithography and the Al second superconducting layer 20 is etched by RIE in step 117 to form a defined overlap junction. Lastly, in step 118, the AlOx protective coating 50 is deposited on the surface of the Josephson junction device 100 by in-situ oxidation of the Al second superconducting electrode layer 20.

Figure 6 shows a schematic illustration of a (top-down) method 140 of manufacture of the Josephson junction device 100 of Figure 4. The method 140 comprises steps 130 to 137 to form the Josephson junction device 100. Step 130 involves preparing the Si substrate 40 for deposition by cleaning with acetone and isopropyl alcohol, followed by irradiating the surface of the Si substrate 40 with O₂ plasma. O₂ plasma functionalises the surface of the Si substrate 40 by forming oxide groups, which facilitates the binding of the photoresist with the Si substrate 40. In step 131, a bilayer resist 60 is formed by spin-coating the Si substrate 40 with MMA and baking, followed by spin-coating with PMMA and baking again to form the bilayer resist 60. In step 132, the bilayer resist 60 is patterned by e-beam lithography and immersed in developer, whereby the difference in solubility between MMA and PMMA results in the bottom MMA layer dissolving faster to form a suspended Dolan bridge structure over an open window. An e-beam evaporator then evaporates Al to form the first superconducting electrode layer 10 in step 133, whereby Al deposits on the visible surfaces from the source direction and not on the area shadowed by the Dolan bridge. In step 134, the Al first superconducting electrode layer 10 is fluorinated in-situ by plasma-assisted fluorination to form the AlF₃ dielectric insulator layer 30. E-beam evaporation occurs again in step 135, whereby the Al second superconducting electrode layer 20 is deposited from the opposite side of the first evaporation in step 133. In this way, the Al second superconducting electrode layer 20 is deposited on the other side of the opening under the bridge and forms a small tunnel junction. The bilayer resist 60 is then dissolved by immersing the device 100 in acetone in the lift-off process of step 136. The resulting geometry of the Josephson junction device is defined by the geometry of the resist bridge. Lastly, in step 137, the AlOx protective coating 50 is deposited on the surface of the Josephson junction device 100 by in-situ oxidation of the Al second superconducting electrode layer 20.

Alternatively the junction can be formed by a deposition of all the layers in PVD (physical vapor deposition) such as e-beam or thermal deposition, or sputtering, and alternatively with an ALD tool. In the intermediate step AlF₃ forms with F-rich plasma. Fabrication of the junction follows by defining the area of the junction, followed by etching of the top electrodes. Afterwards, a top electrode is connected using a bridge type of electrode, and lastly superconducting coarse leads connect to the top and bottom electrode

Thus, the invention has been described by reference to certain embodiments discussed above. It will be recognized that these embodiments are susceptible to various modifications and alternative forms well known to those of skill in the art. In particular, the thickness and materials used for the first and second superconducting electrode layer and the dielectric insulator layer may be distinct from the schematically illustrated design.

Many modifications in addition to those described above may be made to the structures and techniques described herein without departing from the spirit and scope of the invention. Accordingly, although specific embodiments have been described, these are examples only and are not limiting upon the scope of the invention.

## Claims

1. A Josephson junction device (100) comprising:
a substrate (40) having a surface;
a first superconducting electrode layer (10) formed on the surface of the substrate (40);
a dielectric insulator layer (30) formed on a surface of the first superconducting electrode layer (10); and
a second superconducting electrode layer (20) formed on a surface of the dielectric insulator layer (30);
wherein said first and second superconducting electrode layers comprise aluminium, and said dielectric insulator layer comprises Aluminium Fluoride, AlF₃.

2. The Josephson junction device of claim 1, wherein the dielectric insulator layer (30) has a thickness of 0.3 to 2.5 nanometres, preferably a thickness of 1 to 2 nanometres, and more preferably a thickness of 1 to 1.4 nanometres.

3. The Josephson junction device of claim 1, wherein the second superconducting electrode layer (20) has a greater thickness than the first superconducting electrode layer (10).

4. The Josephson junction device of claim 1, wherein each of the first and second superconducting electrode layers and the dielectric insulator layer have are grown epitaxially on the substrate.

5. The Josephson junction device of claim 1, wherein the first superconducting layer and/or the second superconducting layer further comprises at least one of Niobium, Tantalum, Titanium, Thallium and Molybdenum Rhenium, in combination with Aluminium, Al.

6. The Josephson junction device of claim 1, wherein a composition of the first superconducting layer (10) is different to a composition of the second superconducting layer (20).

7. The Josephson junction device of claim 1, wherein the dielectric insulating layer (30) further comprises Alumina, AlO₃.

8. The Josephson junction device of claim 1, wherein a protective coating is formed on a surface of the second superconducting layer.

9. The Josephson junction device of claim 1, wherein the substrate (40) is formed of a material selected from the group consisting of a Magnesium Oxide, Silicon, Silicon Dioxide, Strontium Titanate and yttrium-stabilised zirconia.

10. A process of manufacturing the Josephson junction device of claim 1, comprising the steps of forming on a portion of the planar surface of the substrate a thin film of Aluminium, Al, superconducting layer, further forming a thin film of AlF₃ dielectric insulating layer on the surface of the Al thin film, and further forming a thin film of Al superconducting layer on the surface of the AlF₃ thin film, wherein the thin film layers are grown epitaxially by thin film deposition methods.

11. The process of claim 10, wherein the dielectric insulator layer has a thickness of 0.3 to 2.5 nanometres, preferably a thickness of 1 to 2 nanometres, and more preferably a thickness of 1 to 1.4 nanometres.

12. The process of any of claims 10-11, wherein the second superconducting electrode layer has a greater thickness than the first superconducting electrode layer.

13. The process of any of claims 10-12, wherein each of the first and second superconducting electrode layers and the dielectric insulator layer have are grown epitaxially on the substrate.

14. The process of any of claims 10-13, wherein a composition of the first superconducting layer is different to a composition of the second superconducting layer.

15. The process of any of claims 10-14, wherein a protective coating is formed on a surface of the second superconducting layer.
